Europäisches Patentamt

(19) European Patent Office

Office européen des brevets

(11) Veröffentlichungsnummer: **0 006 602**
**B1**

(12) # EUROPÄISCHE PATENTSCHRIFT

(45) Veröffentlichungstag der Patentschrift:
12.05.82

(51) Int. Cl.³: **G 01 R 31/02, H 01 H 83/04**

(21) Anmeldenummer: 79102101.7

(22) Anmeldetag: 25.06.79

(54) Verfahren und Schaltungsanordnung zur Prüfung von Fehlerstrom- bzw. Fehlerspannungsschutzschaltern.

(30) Priorität: 05.07.78 DE 2829407

(43) Veröffentlichungstag der Anmeldung:
09.01.80 Patentblatt 80/1

(45) Bekanntmachung des Hinweises auf die Patenterteilung:
12.05.82 Patentblatt 82/19

(84) Benannte Vertragsstaaten:
AT CH FR

(56) Entgegenhaltungen:
keine

(73) Patentinhaber: GOSSEN GMBH, Nägelsbachstrasse 25,
D-8520 Erlangen (DE)

(72) Erfinder: Leischner, Manfred, Ing. grad, Kosbacher
Weg 21, D-8520 Erlangen (DE)
Erfinder: Lottes, Hermann, Ing. grad, Strauchstrasse 8,
D-8500 Nürnberg (DE)

(74) Vertreter: Schweinzer, Karl, Dr. Dipl.-Phys.,
Patentanwälte Dipl.-Ing. H. Stehmann Dipl.-Phys. Dr. K.
Schweinzer Essenweinstrasse 4-6,
D-8500 Nürnberg 70 (DE)

## Verfahren und Schaltungsanordnung zur Prüfung von Fehlerstrom- bzw. Fehlerspannungsschutzschaltern

Die Erfindung betrifft ein Verfahren und eine Schaltungsanordnung zur Prüfung von Fehlerstrom- bzw. Fehlerspannungsschutzschalter in einer elektrischen Anlage, bei welchem ein Prüfstrom, der in seiner zeitlichen Kurvenform dem Netzwechselstrom entspricht, für eine definierte Dauer auf den Schutzleiter der Anlage eingespeist wird, und bei welchem die Berührungsspannung gemessen wird.

Fehlerstrom- und Fehlerspannungs-(»FI- und FU-«)Schutzschalter in elektrischen Anlagen sollen verhindern, daß Berührungsspannungen z. B. an Gehäusen von elektrischen Geräten, die über den Schutzleiter geerdet sind, bei Fehlern gefährliche Werte annehmen.

Ein solcher Fehler läge z. B. dann vor, wenn ein Anschlußdraht sich löste und das metallene Gehäuse des betreffenden elektrischen Geräts (z. B. Kochherd) berührte. Hat das Gerät einen korrekten Schutzleiteranschluß, dann bildet sich am Gehäuse keine merkliche Spannung aus.

Mit Prüfgeräten lassen sich FI- und FU-Schutzschalter in elektrischen Anlagen prüfen. Dabei sind je nach speziellem Anwendungszweck verschiedene VDE-Bestimmungen zu beachten, in denen die Prüfbedingungen festgelegt sind (siehe VDE 0100, 0100g, 0413, 0663, 0664).

Im wesentlichen soll die Prüfung dadurch erfolgen, daß auf den Schutzleiter ein Prüfstrom (Netzwechselstrom) eingespeist wird, der möglichst von Null an ansteigen soll bis der betreffende Schutzschalter in der elektrischen Anlage anspricht und die ganze Anlage abschaltet. Das Ansteigen des Prüfstromes erfolgt nach dem Stand der Technik im einfachsten Falle durch das langsame Drehen eines Potentiometers von Hand. Aber auch Schaltungsanordnungen, die ein selbsttätiges Ansteigen des Prüfstromes bewirken, sind bekannt (siehe z. B. DE-C-1 092 125).

Bei einer anderen bekannten Schaltungsanordnung zur Erzeugung eines Prüfstromes zwecks Prüfung von Schutzschaltern (DE-B-2 658 185) ist die Schaltung derart ausgebildet, daß von Null ansteigend jeweils definierte Einzelströme gebildet werden, wobei sich die Einzelströme zum gesamten Prüfstrom summieren, so daß sich ein stufenweise gleichmäßig ansteigender Prüfstrom ergibt. Während des automatischen Anstiegs des Prüfstromes wird entweder die Berührungsspannung gemessen oder der Prüfstrom selbst.

Ferner ist zu prüfen, ob FI- bzw. FU-Schutzschalter auch genügend schnell ansprechen. Mit den meisten bekannten Prüfgeräten ist eine solche Prüfung überhaupt nicht durchführbar. In Sonderfällen wird diese Prüfung in einer zusätzlichen Messung ausgeführt, wodurch der gesamte Zeitaufwand für alle vorgesehenen Einzelprüfungen vergrößert wird. Auch mit der bekannten Schaltungsanordnung gemäß DE-B-2 658 185 kann eine gesonderte zusätzliche Messung zur Prüfung der Ansprechzeit eines Schutzschalters durchgeführt werden, wobei der zu prüfende Schutzschalter mit einem Prüfstromstoß definierter zeitlicher Dauer beaufschlagt wird. Dabei hat der Stromstoß eine definierte Stromstärke, die auf jeden Fall zum Ansprechen des Schutzschalters führt. Die Stromstärke liegt daher im allgemeinen über dem Nennfehlerstrom des jeweiligen Schutzschalters.

Eine wichtige Prüfung während des Anstiegs des Prüfstroms ist die Messung der hierbei auftretenden Berührungsspannung, d. h. der Spannung zwischen Schutzleiter und Erde. Nach dem Stand der Technik wird für die Messung der Berührungsspannung eine Erdsonde angebracht, was in vielen praktischen Fällen erhebliche Schwierigkeiten bringen kann. Zur Vermeidung dieser Schwierigkeiten wird deshalb das Spannungsabsenkungsverfahren angewendet, bei dem die Spannung zwischen Außenleiter und Schutzleiter zweimal gemessen wird:

Zuerst ohne Prüfstrom und dann mit Prüfstrom, der auf den Schutzleiter eingespeist wird. Die dabei ermittelte Spannungsdifferenz ist gleich der Berührungsspannung. Diese Methode hat den Nachteil, daß es bei der ersten Messung Fälle gibt, in denen der Schutzleiter bereits belastet ist und somit Spannung führt. Das führt natürlich zu einer Verfälschung der Berührungsspannung.

Die Schaltungsanordnung gemäß DE-B-2 658 185 ermöglicht auch eine Messung der Berührungsspannung. Bei der bekannten Anordnung wird die Berührungsspannung während des automatischen Anstiegs des Prüfstromes gemessen.

Die bekannten Prüfgeräte bzw. Prüfverfahren haben durchweg den Nachteil, daß eine Prüfung recht lange dauert und in vielen Fällen nur von speziell ausgebildeten Technikern durchgeführt werden kann. Auch bringt die Prüfung der Berührungsspannung in den Fällen Schwierigkeiten, wo ein gesonderter Erdanschluß nicht zur Verfügung steht.

Der Erfindung liegt die Aufgabe zugrunde, FI- und FU-Schutzschalter in elektrischen Anlagen in einfacher und insbesondere schneller Weise, aber trotzdem sicher und verläßlich prüfen zu können.

Die erfindungsgemäße Lösung dieser Aufgabe erfolgt durch die kennzeichnenden Merkmale des Anspruches 1.

Gemäß einer Weiterbildung des erfindungsgemäßen Verfahrens wird zur ''ssung der Berührungsspannung vor Beginn ꝰrüfstromflusses die Spannung zwischen A ꞉nleiter und geerdetem Mittelleiter gemessen und danach die Spannung zwischen Außenleiter und dem mit Prüfstrom belasteten Schutzleiter, wobei die Differenz beider Spannungen die Berührungsspannung ist.

Das erfindungsgemäße Prüfverfahren bietet eine Reihe von Vorteilen. Insbesondere ist die Prüfung von FI-/FU-Schutzschaltern in sehr kurzer Zeit durchführbar. Die Frage einer Erdsonde, eines Erdanschlusses usw. entfällt, da ein gesonderter Erdanschluß nicht benötigt wird. Weiterhin ist es auch sehr vorteilhaft, daß der einstellbare Stromwert des Prüfstroms unabhängig vom Erdnungswiderstand des Schutzleiters ist. Ferner läßt sich ein praktisches Prüfgerät, welches das erfindungsgemäße Prüfverfahren realisiert, mit relativ kleinen Dimensionen herstellen. Auch lassen sich die Prüfungen sehr einfach durchführen.

Es folgt nun die Beschreibung der Erfindungsgedanken anhand der Zeichnung.

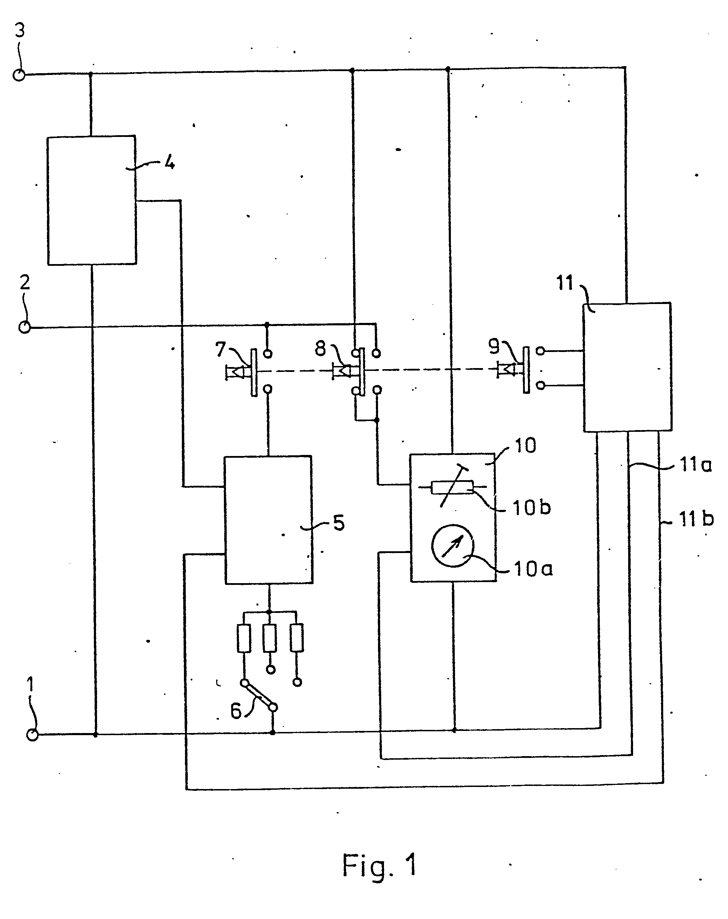

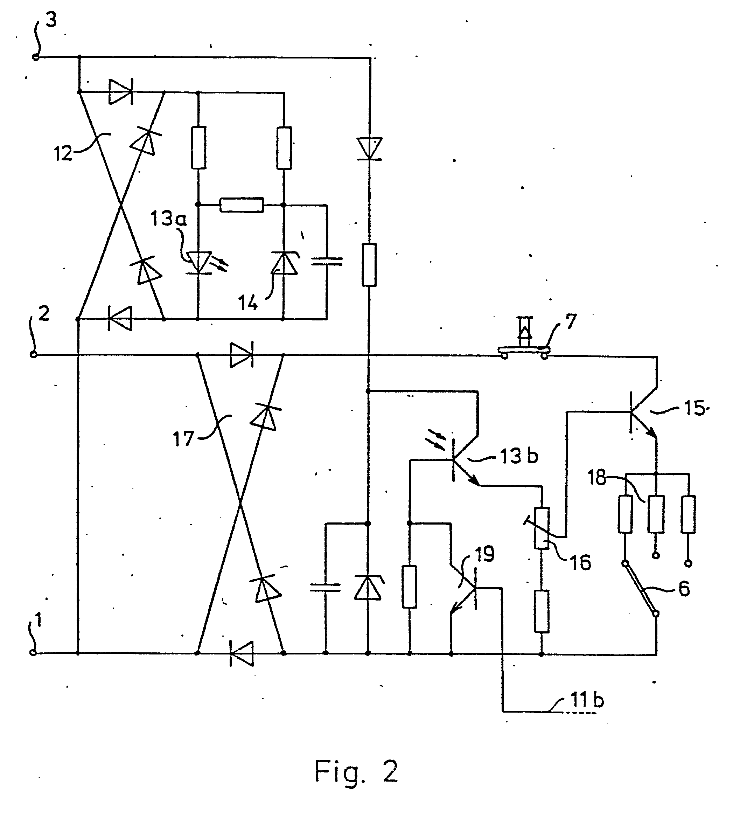

Figur 1 zeigt ein Blockschaltbild, mit dem das Prüfverfahren erläutert wird und Figur 2 eine Schaltungsanordnung zur Erzeugung des Prüfstroms.

Der Anschluß 1 ist mit dem Außenleiter (»Phase«), Anschluß 2 mit dem Schutzleiter und Anschluß 3 mit dem geerdeten Mittelleiter (»Nulleiter«) des Wechselstromnetzes verbunden.

Block 4 enthält einen Gleichrichter und liefert die Steuerspannung für Block 5; dieser enthält die eigentliche Prüfstromerzeugung; mit Umschalter 6 kann der vorgesehene Prüfstromwert, nämlich der Nennfehlerstrom des Schutzschalters eingestellt werden. Die Drucktasten 7, 8, 9 sind mechanisch gekoppelt. In der Ruhestellung der Figur 1 wird über Drucktaste 8 die Spannung zwischen Außenleiter 1 und Mittelleiter 3 im Block 10 gemessen und vom Meßinstrument 10a angezeigt, wobei noch kein Prüfstrom über den Schutzleiter 2 zur Erde abfließt (Drucktaste 7 ist offen). Hierbei kann zur Vereinfachung der Messung mittels Potentiometer 10b das Meßinstrument 10a auf Null eingestellt werden.

Das gleichzeitige Betätigen der drei Drucktasten 7, 8, 9 bewirkt dreierlei:

1. Über Drucktaste 7 fließt der in 5 erzeugte Prüfstrom auf den Schutzleiter 2.
2. Drucktaste 8 schaltet Block 10 auf die Messung der Spannung zwischen Außenleiter 1 und Schutzleiter 2 um.
3. Mit Drucktaste 9 wird Block 11 eingeschaltet, der eine Impulszeitsteuerung beinhaltet. Nach Betätigen der Drucktasten erzeugt dieser Block 11 zwei Signale, die unterschiedlich lang sind. Beide beginnen im Nulldurchgang der Netzwechselspannung, welcher auf die Tastenbetätigung folgt. Über die Steuerleitung 11a steht in Block 10 ein Signal an, das die Dauer einer Wechselspannungshalbwelle (10 ms) hat. Die Dauer könnte auch kürzer gewählt werden, muß aber mindestens den Spitzenwert enthalten. Lediglich über diese kurze Zeitdauer wird die Messung der Spannung zwischen Außenleiter 1 und Schutzleiter 2 freigegeben. Dadurch wird erreicht, daß die beim nachfolgenden Ansprechen des Schutzschalters und dem damit verbundenen Abtrennen der elektrischen Anlage vom Netz möglicherweise auftretenden Abschaltspannungsspitzen bei der Messung nicht mehr erfaßt werden und somit den Meßwert nicht verfälschen. Die Meßschaltung 10 enthält auch eine Meßwertspeicherung, so daß der Meßwert der Spannung längere Zeit gespeichert und vom Meßinstrument 10a angezeigt wird, nachdem die Impulszeitsteuerung 11 die eigentliche Messung bereits hat enden lassen und nachdem der Schutzschalter bereits angesprochen hat und die Anlage und somit auch die Prüfvorrichtung vom Netz getrennt hat.

Neben dem kurzdauernden Signal wird in Block 11 noch ein zweites, länger dauerndes Signal erzeugt, das mit dem ersten zeitgleich, nämlich im gleichen Nulldurchgang beginnt. Dieses über die Steuerleitung 11b an der Konstantstromschaltung von Block 5 anstehende Signal dauert beispielsweise 200 ms und läßt über diese definierte Zeit den Prüfstrom auf den Schutzleiter 2 einfließen.

Die bei der Erfindung verwendete Schaltungsanordnung zur Erzeugung des Prüfstroms ist in Figur 2 gezeigt. Die Spannungsversorgung erfolgt hierbei aus dem Netz durch Anschluß an Außenleiter 1 und an Mittelleiter 3.

Durch die Gleichrichterbrücke 12 wird die Leuchtdiode 13a eines optoelektronischen Kopplers mit gleichgerichteten Halbwellen angesteuert.

Durch die Z-Diode 14 mit Kondensator bekommt die Leuchtdiode 13a eine zusätzliche konstante und geglättete Vorspannung. Da die Leuchtdiode 13a und der Fototransistor 13b eines optoelektronischen Kopplers trägheitsfrei arbeiten, erhält die Basis des Transistors 15 über den einstellbaren Spannungsteiler 16 gleichgerichtete Halbwellen derselben Kurvenform wie nach der Gleichrichterbrücke 12. Daraus folgt, daß der über den Schutzleiter 2 zur Erde abfließende Prüfstrom denselben zeitlichen sinusförmigen Verlauf wie Netzwechselstrom hat.

Der Transistor 15 wirkt als Konstantstromquelle in Emitterschaltung mit Stromgegenkopplung (siehe z. B. Tietze/Schenk: Halbleiterschaltungstechnik, S. 114, Springer-Verlag 1974). Hierfür gilt ganz allgemein, daß die Emitterspannung konstant ist, wenn die Basisspannung konstant ist, und daß demzufolge der Ausgangsstrom, der über den geraden eingeschalteten Widerstand 18 über den Collector und über den Schutzleiter 2 auf Erde abfließt, lediglich von dem gerade eingeschalteten Widerstand 18 abhängig ist. Der Ausgangsstrom, nämlich der Prüfstrom, wird also nicht über die Größe des Erdungswiderstandes des Schutzleiters bestimmt.

Da die Basis des Transistors 15 mit gleichgerichteten Halbwellen angesteuert wird, sind die im Vorhergehenden genannten Spannungen bzw. Ströme stets als Effektivwerte aufzufassen.

Von der Impulssteuerschaltung 11 aus gelangt über die Steuerleitung 11b ein Signal definierter Dauer, vorzugsweise 200 ms, auf die Basis des Transistors 19, welcher den Fototransistor 13b des optoelektronischen Kopplers während dieser Zeit freigibt, so daß der Prüfstrom über Transistor 15 genau diese Zeitdauer hat.

**Patentansprüche**

1. Prüfverfahren für Fehlerstrom- bzw. Fehlerspannungsschutzschalter in einer elektrischen Anlage, bei welchem ein Prüfstrom, der in seiner zeitlichen Kurvenform dem Netzwechselstrom entspricht, für eine definierte Dauer auf den Schutzleiter (2) der Anlage eingespeist wird, und bei welchem die Berührungsspannung gemessen wird, dadurch gekennzeichnet, daß der Effektivwert des Prüfstromes unabhängig vom Erdungswiderstand des Schutzleiters (2) gleich dem Nennfehlerstrom des betreffenden Schutzschalters gewählt ist und daß die Messung der Berührungsspannung zu Beginn des Prüfstromflusses über die Zeitdauer von etwa einer Wechselstrom-Halbwelle durchgeführt wird.

2. Prüfverfahren nach Anspruch 1, dadurch gekennzeichnet, daß zur Messung der Berührungsspannung zunächst vor Beginn des Prüfstromflusses die Spannung des Außenleiters (1) gegen den Mittelleiter (3) und danach die Spannung des Außenleiters (1) gegen den mit Prüfstrom belasteten Schutzleiter (2) gemessen wird, wobei die Berührungsspannung gleich der Differenz beider Spannungen ist.

3. Schaltungsanordnung zur Durchführung des Prüfverfahrens gemäß Anspruch 1, dadurch gekennzeichnet, daß zur Erzielung eines konstanten Prüfwechselstromes ein Transistor (15) mit seinem Emitter über einen umschaltbaren Widerstand (18) an Minus einer Gleichrichterbrücke (17) zwischen Außenleiter (1) und Schutzleiter (2) und mit seinem Kollektor an Plus dieser Gleichrichterbrücke (17) liegt und daß die Basis des Transistors (15) von dem Fototransistor (13b) eines mit der doppelten Netzfrequenz betriebenen optoelektronischen Kopplers ausgesteuert wird, wobei der Steuereingang des Fototransistors (13b) seinerseits über einen Schalttransistor (19) für eine definierte Dauer dadurch freigegeben wird, daß der Schalttransistor (19) einen gleichlangen Steuerimpuls aus einer gesonderten Impulsschaltung (11) erhält.

**Claims**

1. Method of testing fault current breakers or fault voltage circuit breakers in an electrical system or installation, in which method a test current, which in its time curve form corresponds to the mains alternating supply, is fed for a specific period to the earth conductor (2) of the installation, and in which the contact voltage is measured, characterised in that, irrespective of the earthing resistance of the earth conductor (2), the effective value or r.m.s. value of the test current is selected to be equal to the rated fault current of the associated earth conductor, and that the contact voltage is measured at the beginning of test current flow over the duration of approximately one half-wave of alternating current.

2. Test method according to Claim 1, characterised in that, to measure the contact voltage firstly before the test current begins to flow, the voltage of the outer conductor (1) to the central or inner conductor (3) is measured and, subsequently, the voltage of the outer conductor (1) to the earth conductor (2), which is under test current load, is measured, the contact voltage being equal to the difference between the two voltages.

3. Circuit arrangement for putting the test method according to Claim 1 into practice, characterised in that, to achieve a constant alternating test current, a transistor (15) is connected by its emitter via a reversible resistor (18) to the negative of a bridge rectifier (17) between the outer conductor (1) and earth conductor (2) and by its collector to the positive of this bridge rectifier (17), and that the base of the transistor (15) is controlled or driven by the phototransistor of an optocoupler which is operated at twice the mains frequency, the control input of the phototransistor (13b) in turn being cleared or released via a switching transistor (19) for a specific period owing to the fact that the switching transistor (19) receives a control pulse of equal duration from a separate impulse circuit (11).

**Revendications**

1. Procédé de vérification de disjoncteurs de protection à courant de défaut ou à tension de défaut dans une installation électrique, dans lequel on amène pendant une durée définie au conducteur de protection (2) de l'installation un courant de vérification qui correspond au courant alternatif du réseau par sa forme de courbe dans le temps, et dans lequel on mesure la tension de contact, caractérisé en ce que la valeur efficace du courant de vérification est choisie égale au courant de défaut nominal du disjoncteur de protection considéré, indépendamment de la résistance de mise à la terre du conducteur de protection (2), et en ce que l'on exécute la mesure de la tension de contact au début du passage du courant de vérification, sur la durée d'environ une demi-alternance du courant alternatif.

2. Procédé de vérification selon la revendication 1, caractérisé en ce que pour mesurer la tension de contact, on mesure tout d'abord, avant le début du passage du courant de vérification, la tension du conducteur extérieur (1) relativement au conducteur neutre (3) et qu'ensuite, on mesure la tension du conducteur extérieur (1) relativement au conducteur de protection (2) soumis au courant de vérification, la tension de contact étant égale à la différence des deux tensions.

3. Disposition de circuits pour la mise en oeuvre du procédé de vérification selon la revendication 1, caractérisée en ce que pour assurer un courant alternatif de vérification constant, un transistor (15) est relié par son émetteur, par l'intermédiaire d'une résistance commutable (18), au pôle négatif d'un pont redresseur (17) entre conducteur extérieur (1) et conducteur de protection (2), et par son collecteur, au pôle positif de ce pont redresseur (17), et en ce que la base du transistor (15) est commandée par le phototransistor (13b) d'un coupleur opto-électronique fonctionnant au double de la fréquence du réseau, l'entrée de commande du phototransistor (15) étant à son tour libérée par l'intermédiaire d'un transistor de commutation (19) pour une durée définie, en vertu du faut que le transistor de commutation (19) reçoit d'un circuit d'impulsions séparé (11) une impulsion de commande de même longueur.

Fig. 1

Fig. 2